Europäisches Patentamt

European Patent Office

Office européen des brevets

(19)

(11) **EP 0 851 409 A1**

## (12) DEMANDE DE BREVET EUROPEEN

(43) Date de publication:
**01.07.1998 Bulletin 1998/27**

(51) Int. Cl.⁶: **G11B 5/02**, H03F 3/45

(21) Numéro de dépôt: **97203999.4**

(22) Date de dépôt: **18.12.1997**

(84) Etats contractants désignés:
**AT BE CH DE DK ES FI FR GB GR IE IT LI LU MC NL PT SE**
Etats d'extension désignés:
**AL LT LV MK RO SI**

(30) Priorité: **31.12.1996 FR 9616260**

(71) Demandeur:
**Philips Electronics N.V.**
**5621 BA Eindhoven (NL)**

(72) Inventeurs:
• **Voorman, Johannes**
**75008 Paris (FR)**
• **Leclerc, Patrick**
**75008 Paris (FR)**
• **Punch, Fabrice**
**75008 Paris (FR)**

(74) Mandataire: **Caron, Jean**
**Société Civile S.P.I.D.**
**156, Boulevard Haussmann**
**75008 Paris (FR)**

(54) **Système de lecture d'informations magnétiques intégré**

(57)     La présente invention concerne un système de lecture d'informations magnétiques comportant :

.   un barreau magnéto-résistif (MR) et
.   un premier amplificateur différentiel (T1, T2) connecté au barreau magnéto-résistif (MR).

Un système de lecture selon l'invention comporte en outre :

.   un deuxième amplificateur (T3, T4) différentiel disposé en parallèle avec le premier,
.   une première capacité (C) insérée entre le premier transistor (T1) et le barreau magnéto-résistif (MR) et une deuxième capacité (C) insérée entre le quatrième transistor (T4) et le barreau (MR), et
.   un additionneur analogique (ADD) recombinant les signaux de sortie (V01, V02) des premier et deuxième amplificateurs.

Cette structure permet l'intégration des capacités de découplage et évite ainsi l'apparition de résistances et d'inductances externes nuisibles au taux de réjection en mode commun.
Applications : Lecteurs de disques durs.

FIG.1

EP 0 851 409 A1

## Description

La présente invention concerne un système de lecture d'informations magnétiques comportant :

. une tête de lecture munie d'un barreau magnéto-résistif dont la résistivité électrique varie lorsqu'il est soumis à une variation de champ magnétique, le dit barreau présentant une première et une deuxième bornes et étant destiné à être parcouru par un courant de polarisation de valeur prédéterminée,
. un premier amplificateur comprenant un premier et un deuxième transistors montés en paire différentielle, dont les bases sont respectivement reliées aux première et deuxième bornes du barreau magnéto-résistif et dont au moins un collecteur constitue une sortie du premier amplificateur.

Un tel système de lecture est décrit dans l'article "Preparing the preamplifier for the brave new world of MR heads", paru dans DATA STORAGE en Avril 1996. Dans ce système de lecture, une capacité de liaison assure, au sein de l'amplificateur, un découplage de la composante continue du signal présent aux bornes du barreau magnéto-résitif. Cette capacité de liaison est disposée entre les émetteurs des premier et deuxième transistors. Le premier amplificateur présente une bande passante délimitée par une fréquence de coupure basse et une fréquence de coupure haute, laquelle bande passante doit être la plus large possible. Or, la fréquence de coupure basse est ici, en première approximation, de l'ordre de l'inverse de la valeur du produit entre la valeur de la capacité de liaison et la résistance vue depuis les émetteurs des transistors. Cette résistance étant typiquement de l'ordre de la dizaine d'Ohms, une valeur importante est à prévoir pour la capacité de liaison pour obtenir une valeur acceptable de la fréquence de coupure basse. Si l'on souhaite obtenir une fréquence de coupure basse F0 de l'ordre du Mégahertz, la capacité de liaison doit avoir une valeur de l'ordre de la dizaine de Nanofarads, ce qui est très difficile à réaliser sous forme intégrée. Le recours à une capacité externe induit la création d'inductances et de résistances parasites qui sont mal maîtrisées et nuisent au bon fonctionnement du système, particulièrement à haute fréquence, et perturbent de plus la symétrie de l'amplificateur, ce qui dégrade son taux de rejet en mode commun.

Il est possible de remplacer la capacité de liaison mentionnée ci-dessus par deux capacités, dites de découplage, chacune insérée entre la base d'un des transistors et l'une des bornes du barreau magnéto-résistif. Dans un tel amplificateur, la fréquence de coupure basse sera, en première approximation, de l'ordre de l'inverse du produit entre la valeur équivalente des deux capacités de découplage disposées en série et les résistances de base des transistors. Cette résistance étant de l'ordre de cent fois plus grande que la résistance vue depuis les émetteurs, la valeur des capacités de découplage utilisées dans un tel amplificateur pourra être, pour une même fréquence de coupure basse F0 de l'ordre du Mégahertz, de l'ordre de cent fois inférieure à celle de la capacité de liaison présente dans le système de lecture connu. Ceci conduit à une valeur de l'ordre de la centaine de Picofarads, qui reste difficile à réaliser sous forme intégrée.

L'invention a pour but de remédier à cet inconvénient en proposant un système de lecture dont l'architecture permet de réduire considérablement la valeur des capacités de découplage, sans pour autant augmenter la valeur de la fréquence de coupure basse.

En effet, selon la présente invention, un système de lecture d'informations magnétiques tel que décrit dans le paragraphe introductif est caractérisé en ce qu'il comporte en outre :

. un deuxième amplificateur comprenant un troisième et un quatrième transistors montés en paire différentielle, dont les bases sont respectivement reliées aux première et deuxième bornes du barreau magnéto-résistif et dont au moins un collecteur constitue une sortie du deuxième amplificateur,
. une première et une deuxième capacités, de valeurs nominales égales, la première capacité étant insérée entre la base du premier transistor et la première borne du barreau magnéto-résistif, la deuxième capacité étant insérée entre la base du quatrième transistor et la deuxième borne du barreau magnéto-résistif, et
. un additionneur analogique, muni d'une première entrée reliée à la sortie du premier amplificateur, d'une deuxième entrée reliée à la sortie du deuxième amplificateur, et d'une sortie destinée à délivrer un signal représentatif de la somme des valeurs des signaux reçus sur les première et deuxième entrées.

Le fait que les première et deuxième capacités agissent chacune sur une seule entrée de l'un des amplificateurs, ainsi que le dédoublement d'impédance obtenu grâce à la mise en parallèle des premier et deuxième amplificateurs, permet de réduire la valeur des première et deuxième capacités par rapport à la valeur des capacités de découplage décrites plus haut. Il sera démontré dans la suite de l'exposé que le facteur de réduction est au minimum de l'ordre de quatre par rapport à la valeur des capacités de découplage mentionnées ci-dessus. L'ordre de grandeur de la valeur des première et deuxième capacités est alors de quelques dizaines de Picofarads, ce qui est réalisable sous forme intégrée.

Le dédoublement de la fonction d'amplification au moyen des premier et deuxième amplificateurs induit la nécessité de recombiner les sorties des dits amplificateurs, fonction qui est réalisée au moyen de l'additionneur analogique. De nombreux modes de réalisation sont possibles pour cet additionneur. Un mode de réalisation de l'invention présente un système de lecture d'informations magnétiques tel que décrit ci-dessus, caractérisé en ce que l'additionneur analogique comprend :

. un premier et un deuxième modules de type transconductance, chacun étant muni d'une entrée constituant l'une des entrées de l'additionneur et d'une sortie destinée à délivrer un courant proportionnel à la valeur d'une tension reçue sur son entrée, et

. une résistance dont une borne est reliée à une borne de tension fixe et dont l'autre borne est reliée aux sorties des premier et deuxième modules transconductance, la tension aux bornes de la dite résistance constituant le signal de sortie de l'additionneur analogique.

Dans un mode de réalisation particulier de l'invention, chaque module transconductance est constitué d'une paire de transistors dont les émetteurs sont reliés, via des résistances, à une source de courant, dont les bases constituent une entrée symétrique du module transconductance, le collecteur de l'un des transistors constituant la sortie du module transconductance.

Dans la plupart des applications auxquelles un tel système de lecture est destiné, les bases des transistors qui composent les premier et deuxième amplificateurs doivent être soumises à une tension continue dite de polarisation. Cette tension doit être indépendante des variations des tensions alternatives auxquelles sont soumises les dites bases.

Un mode de réalisation préféré de l'invention présente donc un système de lecture d'informations magnétiques tel que décrit plus haut, caractérisé en ce que chaque amplificateur comporte un élément à comportement inductif connecté entre les bases des transistors contenus dans l'amplificateur, le dit élément à comportement inductif comprenant :

. une paire de transistors, dite paire primaire, dont les émetteurs sont reliés à une source de courant, dont les bases sont reliées aux collecteurs des transistors de l'amplificateur, et dont les collecteurs sont reliés entre eux par une capacité, et

. une autre paire de transistors dont les émetteurs sont reliés à une source de courant, dont les bases sont reliées aux collecteurs des transistors de la paire primaire, et dont les collecteurs sont reliés aux bases des transistors de l'amplificateur.

Le comportement inductif des éléments placés entre les bases des transistors de chacun des amplificateurs permet d'attribuer aux dites bases un tension de polarisation fixe et indépendante des variations de tension alternatives auxquelles les bases sont soumises.

L'invention sera mieux comprise à l'aide de la description suivante de quelques modes de réalisation, faite à titre d'exemple non-limitatif et en regard des dessins annexés, dans lesquels :

- la figure 1 présente un schéma décrivant un système de lecture d'informations magnétiques selon l'invention,
- les figures 2a et 2b présentent respectivement un schéma électrique partiel d'un amplificateur muni de capacités de découplage, et un schéma équivalent en petits signaux alternatifs du dit amplificateur,
- les figures 3a et 3b présentent respectivement un schéma équivalent en petits signaux alternatifs équivalent au schéma précédent, et un schéma électrique partiel d'un circuit correspondant,
- la figure 4 présente un schéma électrique décrivant un additionneur analogique inclus dans un mode de réalisation particulier de l'invention, et
- la figure 5 présente un schéma électrique décrivant un élément à comportement inductif inclus dans un mode de réalisation préféré de l'invention.

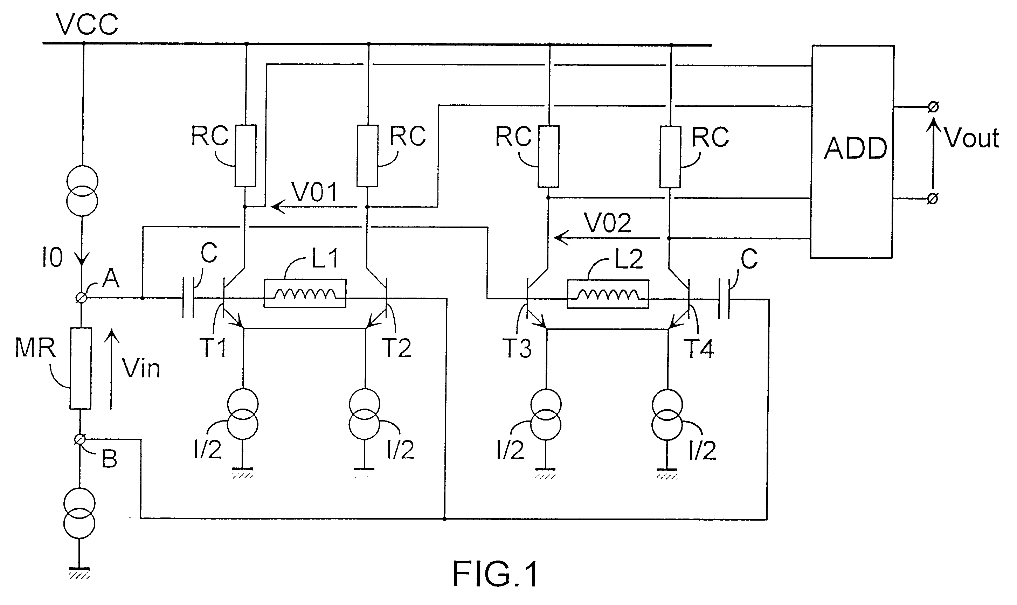

La figure 1 représente partiellement un système de lecture d'informations magnétiques selon l'invention, qui comporte :

. une tête de lecture munie d'un barreau magnéto-résistif MR dont la résistivité électrique varie lorsqu'il est soumis à une variation de champ magnétique, le dit barreau présentant une première et une deuxième bornes, respectivement A et B, et étant destiné à être parcouru par un courant de polarisation I0 de valeur prédéterminée,

. un premier amplificateur comprenant un premier et un deuxième transistors, T1 et T2, montés en paire différentielle, dont les bases sont respectivement reliées aux première et deuxième bornes A et B du barreau magnéto-résistif MR et dont les collecteurs constituent une sortie symétrique du premier amplificateur, délivrant une tension V01.

Ce système de lecture comporte en outre :

. un deuxième amplificateur comprenant un troisième et un quatrième transistors, T3 et T4, montés en paire différentielle, dont les bases sont respectivement reliées aux première et deuxième bornes A et B du barreau magnéto-résistif MR et dont les collecteurs constituent une sortie symétrique du deuxième amplificateur, délivrant une tension V02,

. une première et une deuxième capacités, de valeurs nominales égales à C, la première capacité étant insérée entre la base du premier transistor T1 et la première borne A du barreau magnéto-résistif MR, la deuxième capacité étant insérée entre la base du quatrième transistor T4 et la deuxième borne du barreau magnéto-résistif MR, et

. un additionneur analogique ADD, muni d'une première entrée symétrique reliée à la sortie symétrique du premier amplificateur, d'une deuxième entrée symétrique reliée à la sortie symétrique du deuxième amplificateur, et d'une sortie destinée à délivrer un signal Vout représentatif de la somme des valeurs des signaux V01 et V02 reçus sur les première et deuxième entrées.

Les bases des transistors qui composent les premier et deuxième amplificateurs, respectivement T1, T2 et T3, T4 sont reliées entre elles par des éléments à comportement inductif, respectivement L1 et L2. Ceci permet d'assurer que les bases des dits transistors sont soumises à une tension de polarisation indépendante des variations des tensions alternatives auxquelles sont soumises les dites bases.

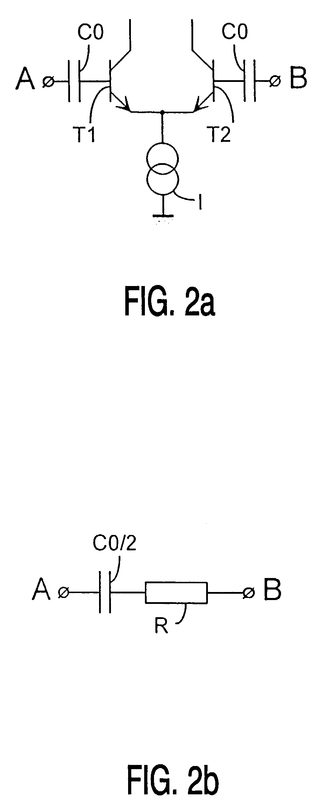

Les figures 2a et 2b présentent respectivement un schéma électrique partiel d'un amplificateur muni de capacités de découplage, et un schéma équivalent en petits signaux alternatifs du dit amplificateur. Ces schémas vont servir à démontrer les avantages de la structure présentée à la figure 1.

La figure 2a représente un amplificateur comprenant un premier et un deuxième transistors, T1 et T2, montés en paire différentielle, dont les bases sont respectivement reliées à des bornes A et B par l'intermédiaire de capacités de découplage dont la valeur est C0. La figure 2b représente un schéma d'un circuit équivalent, en petits signaux alternatifs, à l'amplificateur décrit ci-dessus, vu depuis ses deux bornes d'entrée A et B. En première approximation, ce circuit est composé de deux capacités de valeur C0, qui équivalent à une seule capacité de valeur C0/2, en série avec une résistance R qui représente la résistance d'entrée équivalente de la paire différentielle T1, T2.

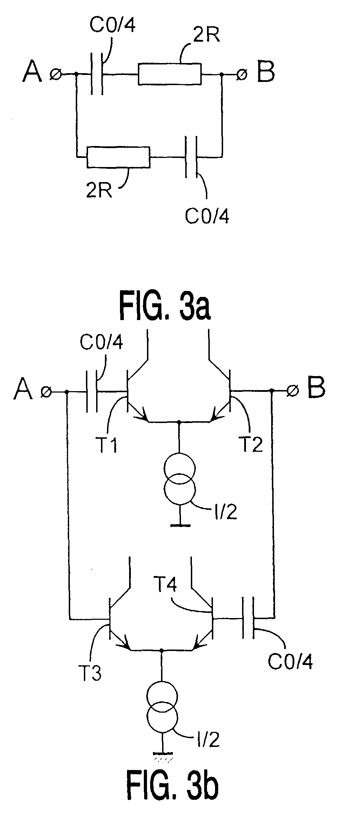

La figure 3a est un schéma en petits signaux alternatifs décrivant un circuit dont l'impédance, vue depuis les bornes d'entrée A et B, est équivalente à celle du circuit représenté à la figure 2b. Le circuit représenté à la figure 3a comprend deux branches disposées en parallèle entre les bornes A et B, chacune composée d'une capacité et d'une résistance disposées en série. Pour avoir l'équivalence avec le schéma précédent, la valeur des capacités doit être de C0/4 et celle des résistances de 2R. La figure 3b est un schéma électrique d'un circuit dont l'impédance, vue depuis ses bornes d'entrée A et B, peut être décrite par le schéma précédent. Ce circuit comporte deux branches disposées en parallèle entre les bornes A et B, chacune composée d'une capacité de valeur C0/4 et d'un amplificateur, disposés en série. Les amplificateurs sont similaires à celui qui est décrit plus haut. Le premier est donc composé d'un premier et d'un deuxième transistors, T1 et T2, montés en paire différentielle, tandis que le deuxième est composé d'un troisième et d'un quatrième transistors, T3 et T4, montés en paire différentielle. Chaque amplificateur devant avoir une résistance d'entrée équivalente égale à 2R, il sont reliés à une source de courant I/2 débitant un courant deux fois plus faible que dans le cas de l'amplificateur représenté à la figure 2a. Les capacités de valeur C0/4 assurent le découplage de la composante continue de la tension présente entre les bornes A et B. Cette architecture est celle qui est utilisée dans le système de lecture conforme à l'invention, représenté à la figure 1. Si les capacités de découplage de valeur C0 permettent d'obtenir une fréquence de coupure basse F0, par exemple de l'ordre du Mégahertz, cette même fréquence de coupure basse F0 est obtenue dans le système de lecture selon l'invention au moyen de capacités de découplage dont la valeur est quatre fois plus faible. Si C0 est de l'ordre de la centaine de Picofarads, et donc difficilement réalisable sous forme intégrée, les première et deuxième capacités C représentées à la figure 1 auront donc une valeur de l'ordre de quelques dizaines de Picofarads, devenant alors intégrables.

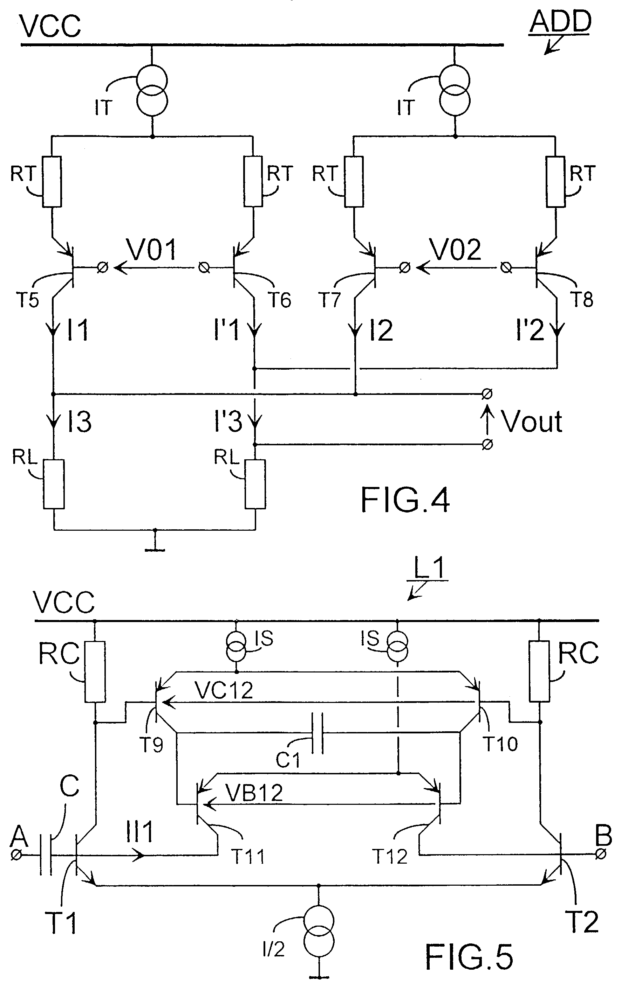

La figure 4 est un schéma électrique décrivant partiellement un additionneur analogique ADD inclus dans un mode de réalisation particulier de l'invention. Cet additionneur comprend un premier et un deuxième modules transconductance, chacun étant constitué d'une paire de transistors respectivement T5, T6 et T7, T8, dont les émetteurs sont reliés, via des résistances RT, à une source de courant IT. Les bases des transistors composant chacun des modules transconductance, respectivement T5, T6 et T7, T8, constituent des entrées symétriques des modules transconductance, recevant respectivement V01 et V02. Les collecteurs des transistors T5, T6 et T7, T8 constituent des sorties de courant symétriques des modules transconductance. Le collecteur du cinquième transistor T5 délivre un courant I1 qui peut être exprimé sous la forme K.(1+x).V01, où K est une constante multiplicative, la valeur de x variant entre 0 et 1 en fonction de la tension V01. Le collecteur du sixième transistor T6 délivre un courant I'1 qui peut être exprimé sous la forme K.(1-x).V01. Le collecteur du septième transistor T7 délivre un courant I2 qui peut être exprimé sous la forme K.(1+x).V02, et le collecteur du huitième transistor T8 délivre un courant I'2 qui peut être exprimé sous la forme K.(1-x).V02. L'additionneur ADD comprend de plus une première et une deuxième résistances RL, chacune ayant une borne reliée à une borne de tension fixe, ici la masse du circuit. La première résistance RL est en outre reliée aux collecteurs des cinquième et septième transistors T5 et T7, tandis que la deuxième résistance RL est reliée aux collecteurs des sixième et huitième transistors T6 et T8. La première résistance RL est donc parcourue par un courant I3 égal à la somme des courants I1 et I2, tandis que la deuxième résistance RL est parcourue par un courant I'3 égal à la somme des courants I'1 et I'2. La différence entre les tensions aux bornes des première et deuxième résistances RL constitue le signal de sortie Vout de l'additionneur ADD. Celui-ci peut donc s'exprimer sous la forme Vout=K'.(V01+V02) , ce qui constitue bien l'équation de sortie recherchée.

La figure 4 est un schéma électrique décrivant un élément à comportement inductif L1 inclus dans un mode de réalisation préféré de l'invention. Cet élément à comportement inductif L1 comprend :

. une paire de transistors T9, T10, dite paire primaire, dont les émetteurs sont reliés à une source de courant IS, dont les bases sont reliées aux collecteurs des transistors T1 et T2 du premier amplificateur, et dont les collecteurs sont reliés entre eux par une capacité C1, et

. une autre paire de transistors T11, T12, dont les émetteurs sont reliés à une source de courant IS, dont les bases sont reliées aux collecteurs des transistors de la paire primaire T9, T10, et dont les collecteurs sont reliés aux bases des transistors T1 et T2.

Si l'on définit les transconductances des transistors T1, T9 et T11 comme étant respectivement égales à gm1, gm2 et gm3, la tension VC12 s'exprime sous la forme -gm1.RC.(VA-VB), tandis que VB12 s'exprime sous la forme -gm2.VC12/(j.2.C.ω), le courant Il1 étant de la forme gm3.VB12/2. Ces trois équations mènent directement à l'équation (VA-VB)/Il1=j.ω.4.C/(gm1.gm2.gm3.RC), ce qui définit l'impédance de l'élément L1. Cette impédance est de la forme j.ω.Leq, qui correspond à un comportement inductif.

## Revendications

1. Système de lecture d'informations magnétiques comportant :

. une tête de lecture munie d'un barreau magnéto-résistif dont la résistivité électrique varie lorsqu'il est soumis à une variation de champ magnétique, le dit barreau présentant une première et une deuxième bornes et étant destiné à être parcouru par un courant de polarisation de valeur prédéterminée,

. un premier amplificateur comprenant un premier et un deuxième transistors montés en paire différentielle, dont les bases sont respectivement reliées aux première et deuxième bornes du barreau magnéto-résistif et dont au moins un collecteur constitue une sortie du premier amplificateur,
caractérisé en ce qu'il comporte en outre :

. un deuxième amplificateur comprenant un troisième et un quatrième transistors montés en paire différentielle, dont les bases sont respectivement reliées aux première et deuxième bornes du barreau magnéto-résistif et dont au moins un collecteur constitue une sortie du deuxième amplificateur,

. une première et une deuxième capacités, de valeurs nominales égales, la première capacité étant insérée entre la base du premier transistor et la première borne du barreau magnéto-résistif, la deuxième capacité étant insérée entre la base du quatrième transistor et la deuxième borne du barreau magnéto-résistif, et

. un additionneur analogique, muni d'une première entrée reliée à la sortie du premier amplificateur, d'une deuxième entrée reliée à la sortie du deuxième amplificateur, et d'une sortie destinée à délivrer un signal représentatif de la somme des valeurs des signaux reçus sur les première et deuxième entrées.

2. Système de lecture d'informations magnétiques selon la revendication 1, caractérisé en ce que l'additionneur analogique comprend :

. un premier et un deuxième modules de type transconductance, chacun étant muni d'une entrée constituant l'une des entrées de l'additionneur et d'une sortie destinée à délivrer un courant proportionnel à la valeur d'une tension reçue sur son entrée, et

. une résistance dont une borne est reliée à une borne de tension fixe et dont l'autre borne est reliée aux sorties des premier et deuxième modules transconductance, la tension aux bornes de la dite résistance constituant le signal de sortie de l'additionneur analogique.

3. Système de lecture d'informations magnétiques selon la revendication 2, caractérisé en ce que chaque module transconductance est constitué d'une paire de transistors dont les émetteurs sont reliés, via des résistances, à une source de courant, dont les bases constituent une entrée symétrique du module transconductance, le collecteur de l'un des transistors constituant la sortie du module transconductance.

4. Système de lecture d'informations magnétiques selon l'une quelconque des revendications 1 à 3, caractérisé en ce que chaque amplificateur comporte un élément à comportement inductif connecté entre les bases des transistors contenus dans l'amplificateur, le dit élément à comportement inductif comprenant :

. une paire de transistors, dite paire primaire, dont les émetteurs sont reliés à une source de courant, dont les bases sont reliées aux collecteurs des transistors de l'amplificateur, et dont les collecteurs sont reliés entre eux par une capacité, et

une autre paire de transistors dont les émetteurs reliés à une source de courant, dont les bases sont reliées aux collecteurs des transistors de la paire primaire, et dont les collecteurs sont reliés aux bases des transistors de l'amplificateur.

FIG.1

**FIG. 2a**

**FIG. 2b**

FIG. 3a

FIG. 3b

FIG.4

FIG.5

**Office européen des brevets**

# RAPPORT DE RECHERCHE EUROPEENNE

Numéro de la demande

EP 97 20 3999

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | US 5 488 330 A (MASUOKA HIDEAKI ET AL) 30 janvier 1996<br>* le document en entier *<br>--- | 1,4 | G11B5/02<br>H03F3/45 |
| A | EP 0 414 328 A (PHILIPS COMPOSANTS ;PHILIPS NV (NL)) 27 février 1991<br>* abrégé *<br>* page 2, ligne 14 - ligne 32 *<br>* page 2, ligne 44 - page 3, ligne 44 *<br>* figures 1,4 *<br>--- | 1,4 | |
| A | EP 0 352 009 A (SONY CORP) 24 janvier 1990<br>* abrégé *<br>* page 2, ligne 19 - page 3, ligne 32 *<br>* page 3, ligne 57 - page 4, ligne 46 *<br>* figures 2,8 *<br>--- | 1,2 | |
| A | US 5 331 478 A (ARANOVSKY ANATOLY) 19 juillet 1994<br>* figure 3 *<br>* colonne 2, ligne 64 - colonne 3, ligne 50 *<br>* colonne 6, ligne 41 - colonne 8, ligne 19 *<br>--- | 1 | **DOMAINES TECHNIQUES RECHERCHES (Int.Cl.6)**<br><br>G06G<br>H03F<br>G11B |
| A | PATENT ABSTRACTS OF JAPAN<br>vol. 007, no. 030 (P-173), 5 février 1983<br>& JP 57 182280 A (FUJITSU KK), 10 novembre 1982,<br>* abrégé *<br>--- | 1-3 | |
| A | PATENT ABSTRACTS OF JAPAN<br>vol. 014, no. 175 (E-0914), 6 avril 1990<br>& JP 02 029010 A (SONY CORP), 31 janvier 1990,<br>* abrégé *<br>---<br>-/-- | 1,4 | |

Le présent rapport a été établi pour toutes les revendications

| Lieu de la recherche | Date d'achèvement de la recherche | Examinateur |
|---|---|---|
| LA HAYE | 1 avril 1998 | Schiwy-Rausch, G |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
 
& : membre de la même famille, document correspondant

EPO FORM 1503 03.82 (P04C02)

**Office européen des brevets**

**RAPPORT DE RECHERCHE EUROPEENNE**

Numéro de la demande

EP 97 20 3999

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | WO 95 35563 A (PHILIPS ELECTRONICS NV ;PHILIPS NORDEN AB (SE)) 28 décembre 1995 ----- | | |

DOMAINES TECHNIQUES RECHERCHES (Int.Cl.6)

Le présent rapport a été établi pour toutes les revendications

| Lieu de la recherche | Date d'achèvement de la recherche | Examinateur |
|---|---|---|
| LA HAYE | 1 avril 1998 | Schiwy-Rausch, G |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

                                                        
& : membre de la même famille, document correspondant

EPO FORM 1503 03.82 (P04C02)